# EUROPEAN PATENT APPLICATION

(11) **EP 2 477 213 A1**
(43) Date of publication of application: **18.07.2012**
(21) Application number: 10815258.8
(22) Date of filing: 24.08.2010
(51) Int. Cl.: H01L 21/336, H01L 29/12, H01L 29/78

(54) **SEMICONDUCTOR DEVICE AND PROCESS FOR PRODUCTION OF SEMICONDUCTOR DEVICE**

(30) Priority: 08.09.2009 JP 2009207206
(71) Applicant: Sumitomo Electric Industries, Ltd., Chuo-ku Osaka-shi Osaka 541-0041 (JP)
(72) Inventor: HONAGA, Misako, Osaka-shi Osaka 554-0024 (JP); MASUDA, Takeyoshi, Osaka-shi Osaka 554-0024 (JP); HARADA, Shin, Osaka-shi Osaka 554-0024 (JP)
(74) Representative: Grünecker, Kinkeldey, Stockmair & Schwanhäusser
(86) International application number: PCT/JP2010/064213
(87) International publication number: WO 2011/030661

(57) **Abstract**

A method of manufacturing a semiconductor device (1) includes the steps of forming a semiconductor layer made of SiC on an SiC substrate, forming a film on the semiconductor layer, and forming a groove (2) in the film. The semiconductor device (1) including a chip (10) having an interlayer insulating film includes a groove (2) formed in the interlayer insulating film to cross the chip (10).

## Description

### TECHNICAL FIELD

The present invention relates to a semiconductor device and a method of manufacturing the semiconductor device.

### BACKGROUND ART

Semiconductor devices including silicon carbide (SiC) are conventionally known (e.g., Japanese Patent Laying-Open No. 10-125905 (PTL 1)). PTL 1 discloses reducing warpage of a semiconductor substrate having an epitaxial layer by performing the following steps.

Specifically, first, an n⁻ type epitaxial layer and a p type epitaxial layer are successively stacked on a surface of an n⁺ type single-crystal SiC semiconductor substrate, to form an SiC substrate. Then, a plurality of grooves are formed in a surface of the SiC substrate with photolithography. The SiC substrate is then placed in a heater and subjected to heat treatment. Consequently, according to PTL 1, internal stress generated during formation of the epitaxial layers is relaxed, and the grooves facilitate movement of the surface of the SiC substrate, to correct warpage of the SiC substrate.

### CITATION LIST

### PATENT LITERATURE

PTL 1: Japanese Patent Laying-Open No. 10-125905

### SUMMARY OF INVENTION

### TECHNICAL PROBLEM

In PTL 1, however, in order to reduce the warpage, the grooves are formed prior to a process of manufacturing a semiconductor device. In general, during a process of manufacturing an SiC semiconductor device, ions are implanted at a high temperature when doping a semiconductor layer with impurities, thus requiring the formation of a thick mask layer. Thus, while the method of manufacturing the semiconductor device described in PTL 1 can correct initial warpage, it is difficult with this method to reduce warpage generated during formation of the mask layer.

In addition, an SiC semiconductor device, which generally has a high breakdown voltage, needs to have a thick insulating film. Thus, with the method of manufacturing the semiconductor device described in PTL 1, it is difficult to reduce warpage generated during formation of the insulating film.

Furthermore, if warpage generated during a manufacturing process cannot be reduced, performance of a manufactured semiconductor device may be lowered due to exposure failure, in-plane variation and the like.

Therefore, an object of the present invention is to provide a method of manufacturing a semiconductor device while reducing warpage generated during a process of manufacturing the semiconductor device.

Another object of the present invention is to provide a semiconductor device of improved performance.

### SOLUTION TO PROBLEM

The present inventors discovered that, when manufacturing a semiconductor device, warpage generated during a process of manufacturing the semiconductor device has a greater influence than warpage of a semiconductor substrate.

For this reason, a method of manufacturing a semiconductor device of the present invention includes the steps of forming a semiconductor layer made of SiC on an SiC substrate, forming a film on the semiconductor layer, and forming a groove in the film.

According to the method of manufacturing a semiconductor device of the present invention, the groove is formed in the film formed on the semiconductor layer. Thus, warpage resulting from the film can be reduced. Therefore, warpage generated during a process of manufacturing the semiconductor device can be reduced.

Preferably, in the above method of manufacturing a semiconductor device, in the step of forming a film, the film is at least one of a mask layer and an insulating film.

If a mask layer is formed for ion implantation, warpage generated in the semiconductor layer can be reduced by forming the groove in the mask layer. If an insulating film is formed in order to realize a semiconductor device having a high breakdown voltage, warpage generated in the semiconductor layer can be reduced by forming the groove in the insulating film.

Preferably, in the above method of manufacturing a semiconductor device, in the step of forming a groove, the groove is formed in a lattice pattern.

Consequently, the groove can be formed readily along a dicing line. Therefore, damage to a chip can be suppressed, and warpage can be reduced during the manufacturing process.

A semiconductor device of the present invention including a chip having an interlayer insulating film includes a groove formed in the interlayer insulating film to cross the chip.

According to the semiconductor device of the present invention, the groove formed in the interlayer insulating film reduces warpage when the interlayer insulating film is formed. Since the device is manufactured with a reduced influence of warpage, variation in performance of semiconductor devices can be suppressed. Further, the groove formed between the chips can suppress damage to the chips. Therefore, a semiconductor device of improved performance can be realized.

### ADVANTAGEOUS EFFECTS OF INVENTION

As described above, according to the method of manufacturing a semiconductor device of the present invention, a semiconductor device can be manufactured while warpage generated during a process of manufacturing the semiconductor device is reduced. Further, according to the semiconductor device of the present invention, a semiconductor device of improved performance can be realized.

### BRIEF DESCRIPTION OF DRAWINGS

Fig. 1 is a schematic cross-sectional view of a semiconductor device in an embodiment of the present invention.
Fig. 2 is a schematic cross-sectional view taken along the line II-II in Fig. 1, schematically showing one chip in the embodiment of the present invention.
Fig. 3 is a flow chart illustrating a method of manufacturing the semiconductor device in the embodiment of the present invention.
Fig. 4 is a schematic cross-sectional view for explaining a step in the method of manufacturing the semiconductor device in the embodiment of the present invention.
Fig. 5 is a schematic cross-sectional view for explaining a step in the method of manufacturing the semiconductor device in the embodiment of the present invention.
Fig. 6 is a schematic cross-sectional view for explaining a step in the method of manufacturing the semiconductor device in the embodiment of the present invention.
Fig. 7 is a schematic cross-sectional view for explaining a step in the method of manufacturing the semiconductor device in the embodiment of the present invention, taken along the line VII-VII in Fig. 6.
Fig. 8 is a schematic cross-sectional view for explaining a step in the method of manufacturing the semiconductor device in the embodiment of the present invention.
Fig. 9 is a schematic cross-sectional view for explaining a step in the method of manufacturing the semiconductor device in the embodiment of the present invention, taken along the line IX-IX in Fig. 8.
Fig. 10 is a schematic cross-sectional view for explaining a step in the method of manufacturing the semiconductor device in the embodiment of the present invention.
Fig. 11 is a schematic cross-sectional view for explaining a step in the method of manufacturing the semiconductor device in the embodiment of the present invention.
Fig. 12 is a schematic cross-sectional view for explaining a step in the method of manufacturing the semiconductor device in the embodiment of the present invention.
Fig. 13 is a schematic cross-sectional view for explaining a step in the method of manufacturing the semiconductor device in the embodiment of the present invention.
Fig. 14 is a schematic cross-sectional view for explaining a step in the method of manufacturing the semiconductor device in the embodiment of the present invention.
Fig. 15 is a schematic cross-sectional view for explaining a step in the method of manufacturing the semiconductor device in the embodiment of the present invention, taken along the line XV-XV in Fig. 14.
Fig. 16 is a schematic cross-sectional view for explaining a step in the method of manufacturing the semiconductor device in the embodiment of the present invention.
Fig. 17 is a schematic cross-sectional view for explaining a step in the method of manufacturing the semiconductor device in the embodiment of the present invention.
Fig. 18 is a schematic diagram showing relation between a groove and a dicing line of the semiconductor device in the embodiment of the present invention.
Fig. 19 is a schematic diagram showing relation between the groove and the dicing line of the semiconductor device in the embodiment of the present invention.
Fig. 20 is a schematic diagram showing relation between the groove and the dicing line of the semiconductor device in the embodiment of the present invention.
Fig. 21 is a schematic diagram showing a modification of the groove of the semiconductor device in the embodiment of the present invention.
Fig. 22 is a schematic diagram showing a modification of the groove of the semiconductor device in the embodiment of the present invention.
Fig. 23 illustrates a warpage state in each process of manufacturing a semiconductor device in the embodiment of the present invention.

### DESCRIPTION OF EMBODIMENTS

An embodiment of the present invention will be described hereinafter with reference to the drawings. It is noted that the same reference numerals are used in the following drawings to indicate the same or corresponding parts, and descriptions thereof will not be repeated.

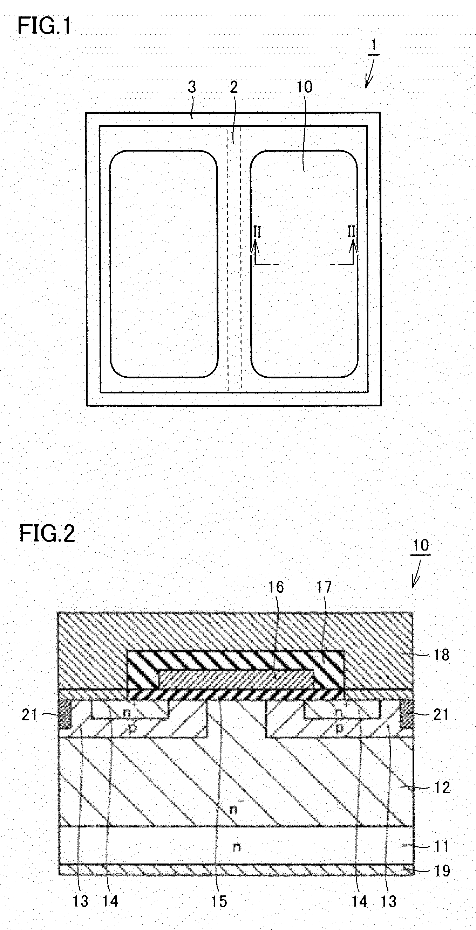

Referring to Figs. 1 and 2, a semiconductor device 1 in an embodiment of the present invention is described. Referring to Figs. 1 and 2, semiconductor device 1 in this embodiment includes a chip 10 having an interlayer insulating film 17. A plurality of chips 10 are partitioned from one another by a groove 2 formed in interlayer insulating film 17 and a dicing line 3. Chips 10 are each a vertical MOSFET (Metal Oxide Semiconductor Field Effect Transistor), for example, as shown in Fig. 2.

As shown in Fig. 2, the MOSFET which is one chip 10 includes a substrate 11, a semiconductor layer 12, a well region 13, a source region 14, an insulating film 15, a gate electrode 16, interlayer insulating film 17, a source electrode 18, and a drain electrode 19.

Substrate 11 is an n type SiC substrate, for example. Formed on this substrate 11 is semiconductor layer 12 made of n⁻ SiC, for example. A mark 21 is formed on a main surface of semiconductor layer 12. This mark 21 is an alignment mark used when a mask layer is formed on semiconductor layer 12.

Well region 13 is located on part of the main surface of semiconductor layer 12 to form a pn junction with semiconductor layer 12. Well region 13 is made of p type SiC, for example. Source region 14 is located on part of a main surface of well region 13 to form a pn junction with well region 13. Source region 14 is made of n⁺ SiC, for example.

Semiconductor layer 12 has the same conductivity type (n) as that of source region 14, and has a lower impurity concentration than that of source region 14. Semiconductor layer 12 has a thickness of 10 µm, for example. The higher or lower level of impurity concentration between semiconductor layer 12 and source region 14 is not particularly limited. It is preferable that source region 14 have a higher impurity concentration than that of semiconductor layer 12, and source region 14 has an impurity concentration of 1×10¹⁸ cm⁻³ to 1×10²⁰ cm⁻³, for example. Nitrogen (N), phosphorus (P) or the like can be used as an n type impurity, for example.

Well region 13 has a second conductivity type (p) different from that of semiconductor layer 12. Aluminum (Al), boron (B) or the like can be used as a p type impurity, for example. Well region 13 has an impurity concentration of 5× 10¹⁵ cm⁻³ to 5×10¹⁸ cm⁻³, for example.

A region in well region 13 sandwiched between source region 14 and semiconductor layer 12 serves as a channel of the MOSFET. While the conductivity types are defined to form an n channel in this embodiment, the first and second conductivity types described above can be reversed to form a p channel.

Insulating film 15 (gate oxide film) is to insulate semiconductor layer 12 from gate electrode 16, and is formed in contact with at least a surface of well region 13 sandwiched between source region 14 and semiconductor layer 12. Insulating film 15 has a thickness of 30 nm or more and 100 nm or less, for example.

Gate electrode 16 is formed on insulating film 15 to at least face well region 13 sandwiched between source region 14 and semiconductor layer 12. Gate electrode 16 may be further formed on another region so long as being formed to face well region 13 located between source region 14 and semiconductor layer 12.

Source electrode 18 is formed on source region 14 to be electrically connected to source region 14. This source electrode 18 is eclectically isolated from gate electrode 16 by interlayer insulating film 17.

As shown in Fig. 1, groove 2 is formed in interlayer insulating film 17 to cross chip 10 to electrically separate the chip 10 from another chip 10. It is preferable that groove 2 be formed in a lattice pattern to surround each chip 10 in semiconductor device 1.

In addition, drain electrode 19 is formed on a surface of substrate 11 opposite to the surface in contact with semiconductor layer 12, to be electrically connected to substrate 11.

Referring now to Figs. 1 to 22, a method of manufacturing semiconductor substrate 1 in this embodiment is described.

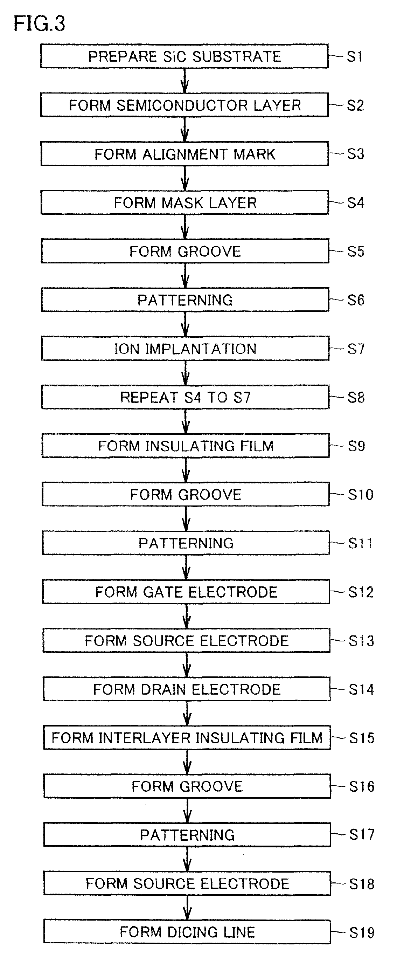

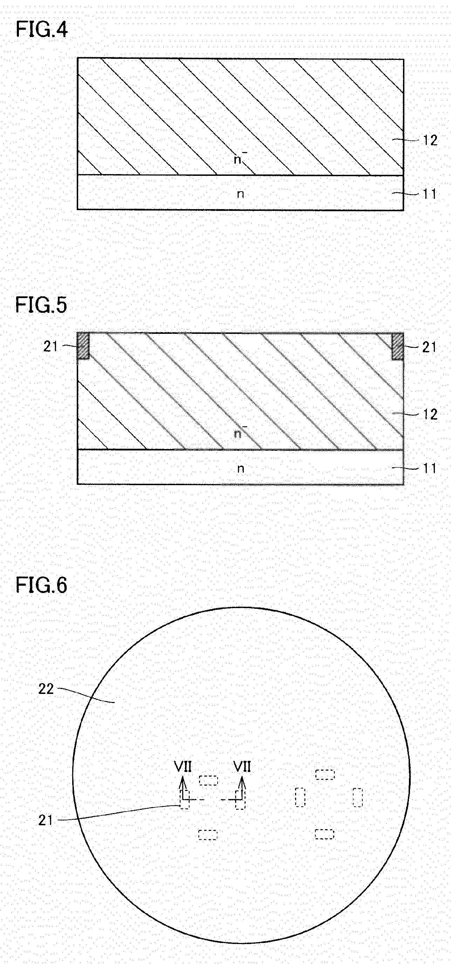

First, as shown in Figs. 3 and 4, substrate 11 is prepared (step S1). In this step S1, an SiC substrate of an n conductivity type is prepared as substrate 11, for example. Alternatively, an SiC substrate having a specific resistance of 0.02 Ωcm may be used as substrate 11, for example.

In this step S1, while polishing or the like may be carried out to reduce warpage of substrate 11 itself, it is preferable to not form a groove in substrate 11.

Next, as shown in Figs. 3 and 4, semiconductor layer 12 made of SiC is formed on substrate 11 (step S2). Specifically, as shown in Fig. 4, semiconductor layer 12 is formed on substrate 11. A method of forming semiconductor layer 12 is not particularly limited, and CVD (Chemical Vapor Deposition) may be employed, for example. Semiconductor layer 12 is made of SiC of an n conductivity type, for example, and has a thickness of 10 µm, for example. An n type impurity concentration in semiconductor layer 12 may have a value of 1 × 10¹⁶ cm⁻³. for example.

In this step S2, while polishing or the like may be carried out to reduce warpage of a stacked body itself including substrate 11 and semiconductor layer 12, it is preferable to not form a groove in semiconductor layer 12.

Next, as shown in Figs. 3 and 5, mark 21 is formed (step S3). Mark 21 is an alignment mark used for alignment of a stepper. A method of forming mark 21 is not particularly limited, and semiconductor layer 12 is irradiated with laser, for example.

Next, as shown in Figs. 3,6 and 7, a mask layer 22 is formed on semiconductor layer 12 (step S4). Mask layer 22 is an oxide film, for example. When mask layer 22 is formed, warpage occurs in a stacked body including substrate 11, semiconductor layer 12 and mask layer 22. Furthermore, when mask layer 22 is formed, mark 21 formed in step S3 becomes less visible.

Next, as shown in Figs. 3, 8 and 9, a groove 22a is formed in mask layer 22 (step S5). In this step S5, groove 22a is formed to expose mark 21 of semiconductor layer 12. In this embodiment, groove 22a is formed to partition the stacked body which is to become the chips, and to expose mark 21.

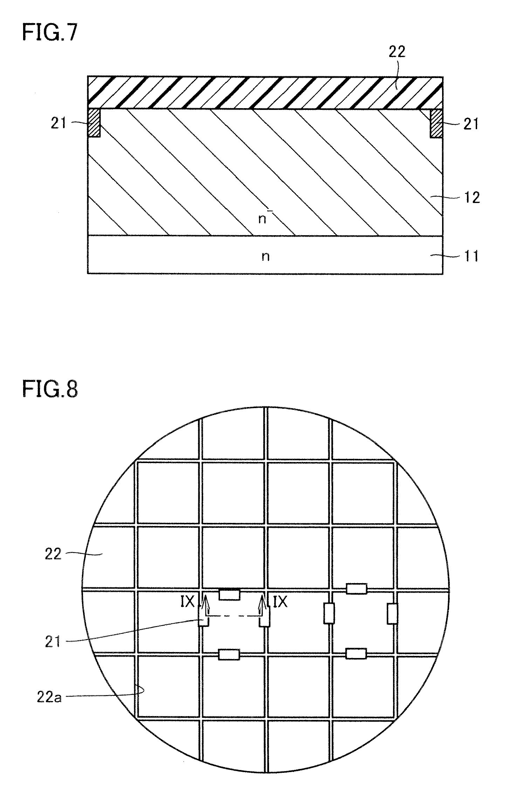

In this step S5, groove 22a is formed in a lattice pattern as shown in Fig. 8. That is, groove 22a is formed in a lattice pattern when viewed from above. The shape of groove 22a is not particularly limited, and a stripe shape may be employed. It is preferable to form groove 22a on a boundary between the chips, and it is more preferable to form groove 22a along dicing line 3 (see Fig. 1) formed in step S 19. In this case, damage to the semiconductor device can be suppressed.

In this step S5, groove 22a finely partitions mask layer 22 into predetermined areas (e.g., 400 mm²) or less, so that stress can be relaxed. By forming groove 22a, therefore, the warpage of the stacked body including substrate 11, semiconductor layer 12 and mask layer 22 can be reduced.

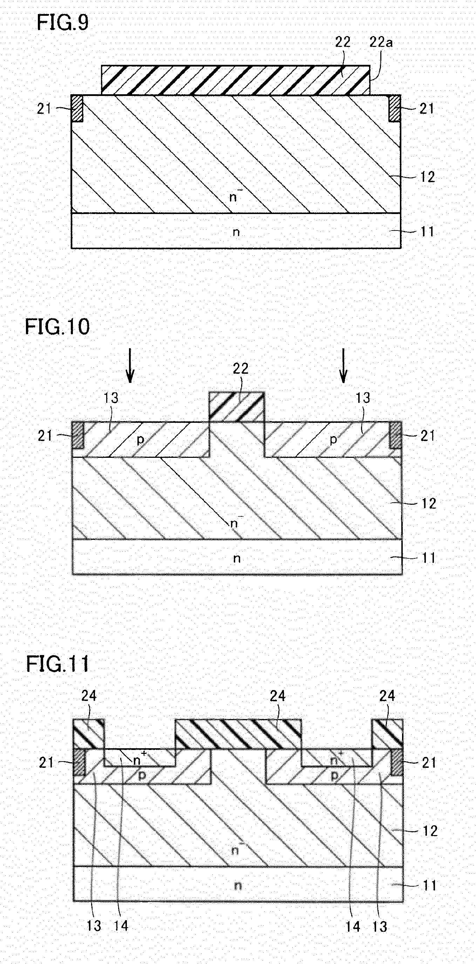

Next, as shown in Figs. 3 and 10, a pattern is formed on mask layer 22 (step S6). In this step S6, a pattern that opens in a region which is to become well region 13 is formed. The pattern can be formed with photolithography, for example. Namely, semiconductor layer 12 having mask layer 22 is set in an exposure device called a stepper, and the mask pattern is transferred, followed by a development process, thereby forming the pattern on mask layer 22.

In this embodiment, the warpage of the stacked body including substrate 11, semiconductor layer 12 and mask layer 22 is reduced in step S5. Thus, influence of the warpage can be reduced during the alignment in step S6, thus reducing variation.

Next, as shown in Figs. 3 and 10, ions are implanted into the region that opens at mask layer 22 having the pattern (step S7). In this step S7, an impurity of a p conductivity type (e.g., A1) is implanted into semiconductor layer 12, thus forming well region 13 as shown in Fig. 10. After the ion implantation, mask layer 22 is removed.

Next, as shown in Fig. 3, the formation of the mask layer (step S4), the formation of the groove (step S5), the patterning (step S6) and the ion implantation (step S7) are repeated (step S8). In this embodiment, as shown in Fig. 11, a new mask layer 24 is formed in order to form source region 14. In order to reduce warpage, a groove is formed in this mask layer 24 as well. After the groove is formed, patterning is performed to form mask layer 24 having a pattern.

When ions are implanted into a region that opens at mask layer 24 having the pattern in order to form source layer 14, an impurity of an n conductivity type (e.g., P) is implanted into semiconductor layer 12.

After the ion implantation in steps S7 and S8, an activation annealing process may be performed. This activation annealing process may be performed with an argon (Ar) gas as an atmospheric gas at a heating temperature of 1700 to 1800°C for a heating period of 30 minutes. As a result of the activation annealing, the impurity in the ion implantation region can be activated, and crystallinity can be recovered.

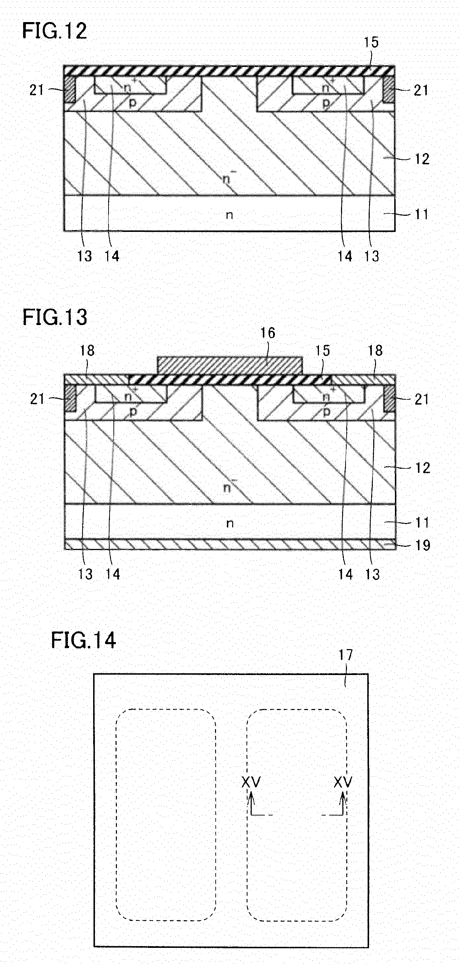

Next, as shown in Figs. 3 and 12, insulating film 15 is formed (step S9). Insulating film 15 to be formed has a thickness of 30 nm or more and 100 nm or less, for example.

Specifically, as shown in Fig. 12, insulating film 15 is formed to cover semiconductor layer 12, well region 13, and source layer 14. Insulating film 15 may be formed by dry oxidation (thermal oxidation), for example. The dry oxidation may be conducted at a heating temperature of 1200°C for a heating period of 30 minutes.

When insulating film 15 is formed in this step S9, warpage occurs in a stacked body including substrate 11, semiconductor layer 12, and insulating film 15.

Next, as shown in Fig. 3, a groove (not shown) is formed in insulating film 15 (step S 10). As a result, the warpage generated in insulating film 15 can be reduced.

After step S9 or S 10, annealing with an Ar gas which is inert gas, for example, may be performed. Specifically, the annealing may be performed with an Ar gas as an atmospheric gas at a heating temperature of 1100°C for a heating period of 60 minutes.

Subsequently, surface cleaning such as organic solvent cleaning, acid cleaning or RCA cleaning may be further performed.

Next, as shown in Figs. 3 and 13, insulating film 15 is subjected to patterning (step S11). In this step S11, in order to form source electrode 18 on source region 14. insulating film 1 located on the source region is removed.

Next, as shown in Figs. 3 and 13, gate electrode 16 is formed (step S12). Specifically, a layer made of high-concentration n type poly Si or the like which is to become gate electrode 16 is formed on insulating film 15 with CVD or the like. On this layer, a resist film having a pattern that opens in a region other than a region which is to become gate electrode 16 is formed with photolithography. In order to reduce warpage of the stacked body, a groove may be formed in this resist film as well. With this resist film as a mask, a layer exposed through the pattern is removed with RIE (Reactive Ion Etching) or the like. As a result, gate electrode 16 can be formed.

Next, as shown in Figs. 3 and 13, source electrode 18 is partially formed (step S13). Specifically, a resist film having a pattern that opens partially in source region 14 is formed with photolithography. A conductor film made of Ni or the like is formed on the pattern and the resist. The resist is then lifted off, to partially form source electrode 18 in contact with source region 14 that opens at insulating film 15.

In addition, drain electrode 19 is formed on a backside of substrate 11 (step S 14). Drain electrode 19 may be made of nickel (Ni), for example. After source electrode 18 and drain electrode 19 are formed, alloying heat treatment is performed, for example. As a result, drain electrode 19 can be formed under substrate 11 s shown in Fig. 13.

Next, as shown in Figs. 3, 14 and 15, interlayer insulating film 17 is formed (step S15). Specifically, an insulating film made of SiO₂ or the like which is to become interlayer insulating film 17 is formed to cover gate electrode 16. A method of forming the insulating film is not particularly limited, and silicon oxide (SiO₂), silicon nitride (Si₃N₄) may be deposited with CVD or plasma CVD, for example. For example, 1 µm of SiO₂ may be deposited by plasma CVD with a source gas of tetraethoxysilane (TEOS) and oxygen (O₂) at a heating temperature of 350°C, for example.

When interlayer insulating film 17 is formed in this step S 11, warpage occurs in a stacked body including substrate 11, semiconductor layer 12, insulating film 15 and gate electrode 16.

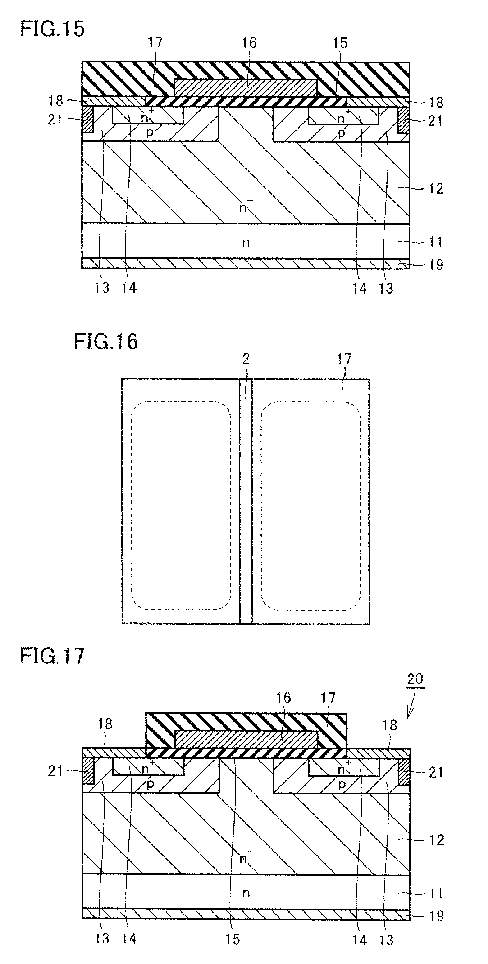

Next, as shown in Figs. 3 and 16, groove 2 is formed in interlayer insulating film 17 (step S 16). By forming groove 2 in this step S 16, warpage of a stacked body including substrate 11, semiconductor layer 12, insulating film 15, gate electrode 16, partial source electrode 18, and interlayer insulating film 17 can be reduced.

A method of forming groove 2 is not particularly limited, and can be formed in a manner similar to that of groove 22a in step S5. Groove 2 may be formed to penetrate interlayer insulating film 17, or may be formed to not reach the backside. It is preferable to form groove 2 in a lattice pattern in interlayer insulating film 17 to partition the stacked body which is to become chips 10. The remaining configuration of groove 2 is similar to that of groove 22a, and thus description thereof will not be repeated.

Next, as shown in Figs. 3 and 17, interlayer insulating film 17 is subjected to patterning (step S17). In this step S17, a resist film having a pattern that opens in a region other than a region which is to become interlayer insulating film 17 (region where source electrode 18 is to be formed) is formed on interlayer insulating film 17 with photolithography. With this resist film as a mask, interlayer insulating film 17 exposed through the pattern is removed with RIE or the like. As a result, a stacked body 20 including interlayer insulating film 17 having the opening, substrate 11, semiconductor layer 12, insulating film 15, and gate electrode 16 can be formed as shown in Fig. 17.

Next, as shown in Figs. 2 and 3, source electrode 18 is formed (step S 18). Specifically, an upper source electrode 18 is formed on previously formed partial source electrode 18. Upper source electrode 18 can be formed with lift-off, etching or the like, for example. As a result, the MOSFET as chip 10 shown in Fig. 2 can be manufactured.

Next, as shown in Figs. 1 and 3, dicing line 3 is formed (step S19). Dicing line 3 partitions the chip into a plurality of chips. A method of forming dicing line 3 is not particularly limited, and a mechanical method may be employed, for example.

By performing above steps S 1 to S19, semiconductor device 1 shown in Fig. 1 can be manufactured.

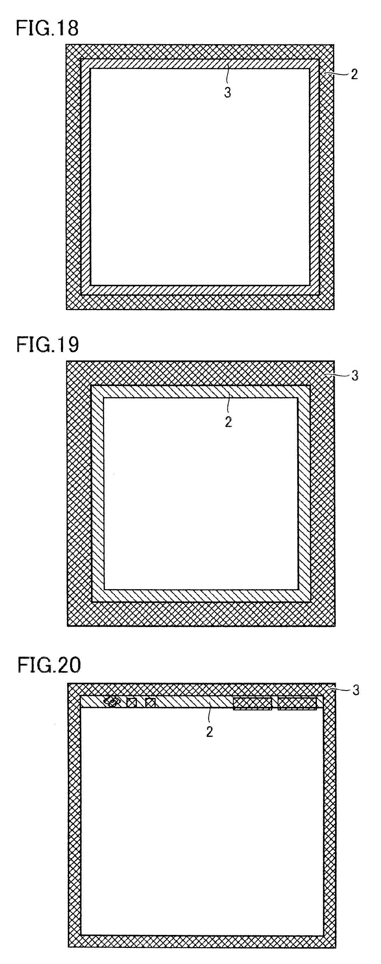

Referring now to Figs. 18 to 21, relation between groove 2 formed in interlayer insulating film 17 and dicing line 3 is described. In Figs. 18 to 21, for the purpose of clarifying the positions of groove 2 and dicing line 3, the remaining configuration that appears when semiconductor device 1 is viewed from above is not illustrated.

As shown in Fig. 18, groove 2 may overlap and be narrower than dicing line 3. Alternatively, as shown in Fig. 19, groove 2 may overlap and be wider than dicing line 3. Alternatively, as shown in Fig. 20, groove 2 may be formed to entirely cover dicing line 3.

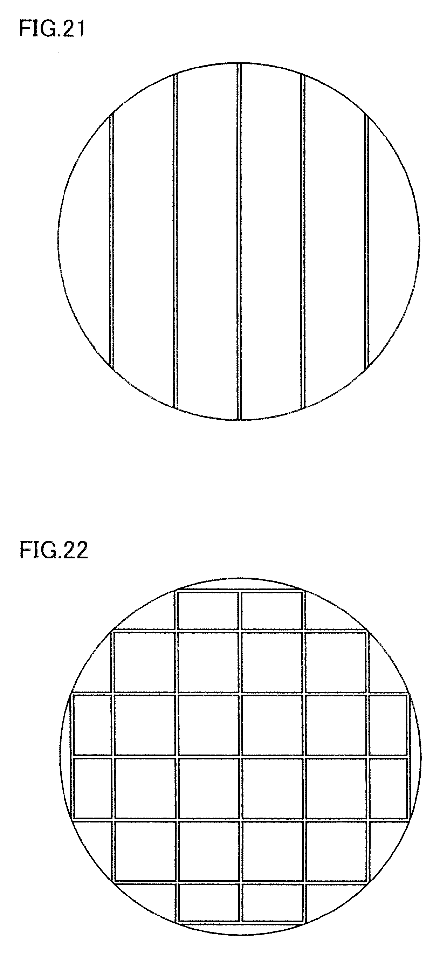

The groove for reducing the warpage may be formed in a lattice pattern as shown in Fig. 8, or in stripes as shown in Fig. 21, or in a shape to form a plurality of rectangles as shown in Fig. 22.

While one chip 10 is formed in a region surrounded by groove 2 formed in interlayer insulating film 17 in this embodiment, a plurality of chips 10 may be formed therein.

While chip 10 has been described as a MOSFET by way of example in this embodiment, chip 10 is not particularly limited as such, but is applicable to a JFET (Junction Field-Effect Transistor), a pn diode, an SBD (Schottky Barrier Diode), an IGBT (Insulated Gate Bipolar Transistor) or the like.

As described above, the method of manufacturing semiconductor device 1 in this embodiment includes the step of forming semiconductor layer 12 made of SiC on SiC substrate 11 (step S2), the steps of forming the films on semiconductor layer 12 (steps S4, S9, S15), and the steps of forming the grooves in the films (steps S5, S10, S16).

According to the method of manufacturing semiconductor device 1 of the present invention, the groove is formed in the film formed on semiconductor layer 12 (formed film), rather than in substrate 11 or semiconductor layer 12. The present inventors completed the present invention by taking note of warpage resulting from a film formed during the process of manufacturing semiconductor device 1 rather than warpage of substrate 11. Accordingly, warpage resulting from the film can be reduced. As a result, the process of manufacturing semiconductor device 1 can proceed while warpage generated during the process is reduced as appropriate. Moreover, since the warpage is reduced by forming the groove, generated warpage can be reduced regardless of the type of a film. Thus, warpage generated during the process of manufacturing semiconductor device 1 can be reduced. As a result, exposure failure and in-plane variation can be suppressed, thereby manufacturing semiconductor device 1 of improved performance.

In particular, since the warpage resulting from the film formation is reduced prior to patterning, the patterning can be performed with a reduced influence of warpage, thus improving patterning accuracy. As a result, variation in performance of manufactured semiconductor devices 1 can be suppressed, thereby manufacturing a semiconductor device of improved performance.

Moreover, since the groove is not directly formed in substrate 11 and semiconductor layer 12, damage to substrate 11 and semiconductor layer 12 can be suppressed.

Furthermore, since semiconductor device 1 is an SiC semiconductor device, ions need to be implanted at a high temperature. For this reason, a mask layer needs to have a great thickness. When the mask layer is formed, therefore, warpage tends to occur. Likewise, an SiC semiconductor device is required to have a high breakdown voltage, and thus needs to have a thick insulating film. In this embodiment, however, the groove is formed for reducing warpage after the mask layer and the insulating film are formed. Accordingly, if a thick mask layer and a thick insulating film are formed, the process can proceed with a reduced influence of warpage. Therefore, the method of manufacturing semiconductor device 1 in this embodiment is suitable as a method of forming an SiC semiconductor device.

Semiconductor device 1 in this embodiment including chip 10 having interlayer insulating film 17 includes groove 2 formed in interlayer insulating film 17 to cross chip 10.

According to semiconductor device 1 in this embodiment, the groove formed in interlayer insulating film 17 reduces warpage generated after interlayer insulating film 17 is formed. Semiconductor device 1 is thus manufactured with a reduced influence of warpage, thereby suppressing variation in performance of semiconductor devices 1. Further, groove 2 formed between chips 10 can suppress damage to chips 10, thereby realizing semiconductor device 1 of improved performance.

### EXAMPLES

In this example, the effect of providing a step of forming a groove in a film formed on a semiconductor layer was examined.

### (Samples a to c)

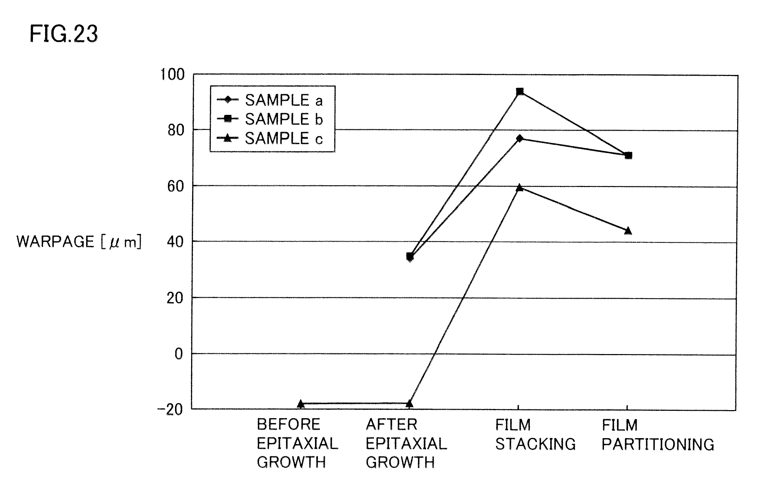

Samples a to c were made by the following steps. Specifically, first, SiC substrates were prepared. Warpage of the SiC substrate of sample c was measured. The warpage was measured with light interference fringes. The result is shown as "before epitaxial growth" in Fig. 23. In Fig. 23, the warpage being 0 means that a measured surface is parallel to a horizontal reference surface.

Next, a semiconductor layer made of SiC was formed on the SiC substrates. Warpage of samples a to c after forming the semiconductor layer was measured in a manner similar to above. The results are shown as "after epitaxial growth" in Fig. 23.

Next, an insulating film made of SiO₂ was formed on the semiconductor layers. Warpage of samples a to c after forming the insulating film was measured in a manner similar to above. The results are shown as "film stacking" in Fig. 23.

Next, a groove in a lattice pattern having a width of 100 µm was formed in the insulating films. Warpage of samples a to c after forming the groove was measured in a manner similar to above. The results are shown as "film partitioning" in Fig. 23.

### (Measurement Results)

As shown in Fig. 23, the warpage of all of samples a to c could be significantly reduced by forming the groove in the insulating films. It was thus found that warpage generated during a process of manufacturing a semiconductor device can be reduced by forming a groove in a film.

In addition, referring to sample c, it was found that the warpage generated when the insulating film was formed was much more greater than the warpage generated when the semiconductor layer made of SiC was formed on the SiC substrate. It was thus found that deterioration in performance of a semiconductor device can be suppressed by reducing warpage generated when an insulating film is formed.

Based on the above findings, according to this example, it was confirmed that warpage generated during a process of manufacturing a semiconductor device could be effectively suppressed by providing a step of forming a groove in a film formed on a semiconductor layer. It was also confirmed that, with regard to warpage generated during a process of manufacturing a semiconductor device, warpage generated during the manufacturing process after forming a semiconductor layer had a greater influence than warpage of a semiconductor substrate.

Although the embodiments and examples of the present invention have been described above, it is also originally intended to combine the features of the embodiments and examples as appropriate. Moreover, it should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### REFERENCE SIGNS LIST

1 semiconductor device; 2 groove; 3 dicing line; 10 chip; 11 substrate; 12 semiconductor layer; 13 well region; 14 source region; 15 insulating film; 16 gate electrode; 17 interlayer insulating film; 18 source electrode; 19 drain electrode; 20 stacked body; 21 mark; 22, 24 mask layer; 22a groove.

## Claims

1. A method of manufacturing a semiconductor device (1), comprising the steps of:
forming a semiconductor layer (12) made of silicon carbide on a silicon carbide substrate (11);
forming a film on said semiconductor layer (12); and
forming a groove in said film.

2. The method of manufacturing a semiconductor device (1) according to claim 1, wherein
in said step of forming a film, said film is at least one of a mask layer (22, 24) and an insulating film (15, 17).

3. The method of manufacturing a semiconductor device (1) according to claim 1, wherein
in said step of forming a groove, said groove is formed in a lattice pattern.

4. A semiconductor device (1) including a chip (10) having an interlayer insulating film (17), comprising a groove (2) formed in said interlayer insulating film (17) to cross said chip (10).
